# EUROPÄISCHE PATENTANMELDUNG

(11) **EP 3 064 950 A1**
(43) Veröffentlichungstag der Anmeldung: **07.09.2016**
(21) Anmeldenummer: 16000428.9
(22) Anmeldetag: 22.02.2016
(51) Int. Cl.: G01R 29/08, G01R 31/00

(54) **PRÜFKAMMER FÜR EMV-MESSPRÜFUNGEN**

(30) Priorität: 24.02.2015 DE 102015102636
(71) Anmelder: Opitz, Wolfgang, 91180 Heideck (DE)
(72) Erfinder: Opitz, Wolfgang, 91180 Heideck (DE)
(74) Vertreter: Schneider, Andreas

(57) **Zusammenfassung**

Die Erfindung betrifft eine Prüfkammer (1) für die EMV-Meßprüfung sowie ein Verfahren zur Validierung und ein Verfahren zur Durchführung von EMV-Meßprüfungen in einer solchen Prüfkammer (1). Um die Validierung einer EMV-Prüfkammer (1) sowie die Durchführung unterschiedlicher EMV-Meßprüfverfahren in einer einzigen Prüfkammer (1) zu vereinfachen, wird eine Prüfkammer (1) für die EMV-Meßprüfung vorgeschlagen, die zur Durchführung unterschiedlicher EMV-Meßprüfverfahren durch Bereitstellung mehrerer Meßanordnungen (13, 14, 15) mit unterschiedlichen Meßachsen (16, 17, 18) ausgebildet ist, in der mehrere Antennen (31, 32, 33, 34) gleichzeitig angeordnet sind, wobei jede dieser Antennen (31, 32, 33, 34) jeweils mindestens einem der Meßprüfverfahren zugeordnet ist und wobei jede dieser Antennen (31, 32, 33, 34) zur Bereitstellung der Meßanordnung (13, 14, 15) für das jeweilige Meßprüfverfahren von einer Ruheposition (41, 42, 43, 44) in eine dieser Meßanordnung (13, 14, 15) zugeordnete Meßposition (24, 25, 26, 27, 28) und zurück bewegbar ist.

## Beschreibung

Die Erfindung betrifft eine Prüfkammer für die EMV-Meßprüfung, ein Verfahren zur Validierung einer solchen Prüfkammer sowie ein Verfahren zur Durchführung von EMV-Meßprüfungen in einer solchen Prüfkammer.

Die elektromagnetische Verträglichkeit (EMV) von elektrischen und elektronischen Geräten unterliegt strengen Prüfanforderungen. Dabei werden in einer geeigneten Prüfkammer die Störaussendung (Emission) sowie die Störfestigkeit (Immunität) dieser Geräte geprüft. Meßverfahren und Grenzwerte für die EMV-Meßprüfung sind in entsprechenden Normen geregelt. Diese sind dem Fachmann bekannt und es braucht daher an dieser Stelle darauf nicht weiter eingegangen werden.

Voraussetzung für eine solche normgerechte EMV-Meßprüfung ist dabei stets eine validierte, normgerechte Prüfkammer. Hierzu muß die Prüfkammer bestimmte Validierungsnormen erfüllen, die nachfolgend näher erläutert werden.

Zur Überprüfung der Störaussendung in einem Frequenzbereich zwischen 30 MHz und 1 GHz wird bei der Validierung der Prüfkammer die Normierte Meßplatzdämpfung (Normalized Site Attenuation, NSA) bei Meßentfernungen von drei Meter und zehn Meter nach den Validierungsnormen CISPR 16-1-4/ EN 55016-1-4 und ANSI C63.4 in einer Prüfkammer mit metallischer Bodenreferenz, also ohne Bodenabsorber, überprüft.

Zur Überprüfung der Störaussendung in einem Frequenzbereich zwischen 1 GHz und 18 GHz wird bei der Validierung der Prüfkammer das SVSWR (Site Voltage Standing Wave Ratio, Meßplatz-Stehwellenverhältnis) nach der Validierungsnorm CISPR 16-1-4/ EN 55016-1-4 geprüft. Dabei kommen Bodenabsorber zum Einsatz.

Zur Überprüfung der Störfestigkeit in einem Frequenzbereich von 80 MHz bis 18 GHz wird bei der Validierung der Prüfkammer die Feldhomogenität (Field Uniformity) nach der Validierungsnorm EN 61000-4-3 in zwei Frequenzbereichen von 1 bis 18 GHz sowie von 80 MHz bis 1 GHz geprüft. Dabei kommen ebenfalls Bodenabsorber zum Einsatz.

Jede dieser Validierungsprüfungen zur Validierung der Prüfkammer erfordert für eine normenkonforme Durchführung die Einhaltung einer Vielzahl von Rahmenbedingungen, insbesondere hinsichtlich der Eigenschaften der Meßanordnungen (Art der verwendeten Antennen, Lage der Meßachsen, Meßabstände, Größe des Prüfvolumens usw.) sowie hinsichtlich der Eigenschaften der Prüfkammer (Eigenschaften der Wand- und Deckenabsorber, Verwendung von Bodenabsorbern usw.).

Alle aus dem Stand der Technik bekannten Lösungen sehen daher zwischen der Ausführung der verschiedenen Validierungsprüfungen und im weiteren der verschiedenen EMV-Meßprüfungen umfangreiche Umbauarbeiten im Inneren der Prüfkammer vor, einschließlich des Ein- bzw. Ausbaus von Prüfequipment (Antennen, Bodenabsorber bzw. Bodenabsorberfelder), da sonst wegen der gegenseitigen Beeinflussung des Prüfequipments keine normenkonforme Messungen erfolgen können.

Diese Umbauten sind sehr aufwendig, zeit- und kostenintensiv. Dabei besteht die Gefahr, daß das empfindliche Prüfequipment beschädigt wird. Durch den Ein- und Ausbau von Prüfequipment kann sich zudem die Meßqualität ändern, so daß eine sichere Reproduzierbarkeit von Meßergebnissen nicht immer gewährleistet ist.

Eine Aufgabe der vorliegenden Erfindung ist es, die EMV-Meßprüfung in einer geeigneten Prüfkammer zu vereinfachen. Insbesondere soll die Durchführung unterschiedlicher EMV-Meßprüfungen in eiher einzigen Prüfkammer vereinfacht werden. Diese Aufgaben werden durch eine Prüfkammer nach Anspruch 1 bzw. durch ein Verfahren nach Anspruch 9 bzw. durch ein Verfahren nach Anspruch 11 gelöst.

Demnach ist die erfindungsgemäße Prüfkammer für die EMV-Meßprüfung zur Durchführung unterschiedlicher EMV-Meßprüfverfahren durch Bereitstellung mehrerer Meßanordnungen mit unterschiedlichen Meßachsen ausgebildet. In der Prüfkammer sind mehrere Antennen gleichzeitig angeordnet, wobei jede dieser Antennen jeweils mindestens einem der Meßprüfverfahren zugeordnet ist. Jede dieser Antennen ist zur Bereitstellung der Meßanordnung für das jeweilige Meßprüfverfahren von einer Ruheposition in eine dieser Meßanordnung zugeordnete Meßposition und zurück bewegbar.

Das erfindungsgemäße Verfahren zur Validierung einer solchen Prüfkammer zeichnet sich dadurch aus, daß sich während der Validierung dieser Prüfkammer jeweils eine dieser Antennen zur Bereitstellung einer zu validierenden Meßanordnung in einer dieser Meßanordnung zugeordneten Meßposition befindet, während sich die jeweils anderen Antennen in ihren von ihren Meßpositionen verschiedenen Ruhepositionen befinden.

Das erfindungsgemäße Verfahren zum Betrieb einer solchen Prüfkammer für die EMV-Meßprüfung zeichnet sich dadurch aus, daß in der Prüfkammer unterschiedliche EMV-Meßprüfverfahren durchgeführt werden, indem nacheinander mehrere Meßanordnungen mit unterschiedlichen Meßachsen bereitgestellt werden, wobei in der Prüfkammer mehrere Antennen gleichzeitig angeordnet sind, wobei jede dieser Antennen jeweils mindestens einem der Meßprüfverfahren zugeordnet ist und wobei jeweils eine dieser Antennen zur Bereitstellung der Meßanordnung für das jeweilige Meßprüfverfahren von einer Ruheposition in eine dieser Meßanordnung zugeordnete Meßposition bewegt wird.

Vorteilhafte Ausführungsformen der Erfindung sind in den Unteransprüchen angegeben.

Die im Folgenden im Zusammenhang mit der Prüfkammer erläuterten Vorteile und Ausgestaltungen gelten sinngemäß auch für die erfindungsgemäßen Verfahren und umgekehrt.

Eine grundlegende Idee der Erfindung ist es, mehrere Meßanordnungen mit unterschiedlichen Meßachsen zur Durchführung unterschiedlicher EMV-Meßprüfverfahren in ein und derselben Prüfkammer bereitzustellen. In einer solchen erfindungsgemäßen "Hybrid"-Prüfkammer können mit anderen Worten mehrere Meßanordnungen mit voneinander verschiedenen Meßachsen realisiert werden. Vorzugsweise werden drei Meßachsen mit einer Meßentfernung von beispielsweise 3 bis 10 Metern in einer einzigen Prüfkammer untergebracht. Vorzugsweise ist die Prüfkammer dabei als Halbabsorberraum (semi anechoic chamber) ausgeführt. Auf diese Weise kann das gesamte Spektrum der Störfestigkeits- und Emissionsmessung unter Verwendung einer einzigen solchen Prüfkammer abgedeckt werden. Der Wechsel zwischen verschiedenen Meßanordnungen erfolgt, indem die entsprechenden Komponenten des Prüfequipments, insbesondere Antennen und gegebenenfalls Bodenabsorber, von einer Ruheposition in die benötigte Meßposition bewegt werden. Wenn hier von Bodenabsorbern gesprochen wird, handelt es sich zumeist um Bodenabsorberfelder. Das Bewegen der Antennen und Bodenabsorber erfolgt entweder manuell oder automatisiert. Bei einer vollautomatisierten Lösung kann somit besonders einfach auch ein automatischer Testlauf eines oder auch mehrerer Meßprüfverfahren realisiert werden. Aber auch bei einer rein manuellen Ausführung vereinfacht sich der Verfahrensablauf zwischen den einzelnen Meßprüfungen.

Vor den eigentlichen EMV-Meßprüfungen findet stets eine Validierung der erfindungsgemäßen Prüfkammer statt. Dabei werden sämtliche von der Prüfkammer bereitgestellte Meßanordnungen auf Einhaltung der bekannten Validierungsnormen geprüft. Hierzu befinden sich die jeweils zu prüfenden Antennen und Bodenabsorber in ihren Meßpositionen, während sich diejenigen Antennen und Bodenabsorber, die gerade keiner Prüfung unterzogen werden, in ihren Ruhepositionen befinden. Diese validierten ("geprüften") Meßanordnungen bilden die Grundlage für die spätere ) normenkonforme EMV-Meßprüfung. Es kann eine Validierung sämtlicher Meßanordnungen anläßlich einer Gesamtvalidierung der Prüfkammer erfolgen, es können aber auch einzelne Meßanordnungen in größeren zeitlichen Abständen validiert werden.

Mit der vorliegenden Erfindung wird eine EMV-Meßprüfung möglich, bei der kein aufwendiger Umbau des Testprüffeldes und des Prüfaufbaus erforderlich wird. Das gesamte Prüfequipment kann dauerhaft, d.h. auch während der Durchführung sämtlicher Meßprüfverfahren, im angeschlossenen Zustand in der Prüfkammer verbleiben. Es entfallen nicht nur lange Umrüstzeiten. Da ein Ein- und Ausbau von Prüfequipment in bzw. aus der Prüfkammer nicht mehr notwendig ist, entfällt auch die Notwendigkeit, externen Lagerplatz für gerade nicht benötigte Ausrüstung vorzuhalten.

Beschädigungen an dem Prüfequipment durch häufiges Handhaben und Transportieren sind quasi ausgeschlossen. Gleiches gilt im Prinzip auch für Fehlbedienungen, da einmal definierte Meß- und Ruhepositionen unverändert eingenommen werden. Damit wird auch auf einfache Weise sichergestellt, daß die Meßprüfungen reproduzierbar sind und die Qualität der Prüfungen konstant bleibt. Im Ergebnis wird die EMV-Meßprüfung gegenüber der herkömmlichen Technik deutlich vereinfacht und alle erforderlichen Meßprüfverfahren können schneller und effizienter durchgeführt werden.

Im Vergleich zu herkömmlichen Meßplätzen sind durch die Erfindung zudem besonders platzsparende Lösungen mit sehr kompakten Prüfkammern möglich, auch wenn diese eine unregelmäßige Form, insbesondere einen unregelmäßigen Grundriß aufweisen. Mit der vorliegenden Erfindung können normenkonform eine Mehrzahl an Meßanordnungen und damit eine Mehrzahl an Meßachsen in einer einzigen Prüfkammer untergebracht werden, auch wenn es sich dabei um unregelmäßige, asymmetrische Kammer handelt. Mit anderen Worten kann die Anordnung der Antennen und Bodenabsorber oder Bodenabsorberfelder in der Prüfkammer und damit die Plazierung von unterschiedlichen Meßanordnungen der Form der Prüfkammer entsprechend ausgeführt werden. Die Erfindung erlaubt anders ausgedrückt also nicht nur, asymmetrische Prüfkammern zu verwenden, sondern ermöglicht zugleich die Anordnung mehrerer Meßanordnungen in einer Prüfkammer, wodurch die Durchführung der EMV-Meßprüfungen, aber auch die vorherige Validierung der Prüfkammer, gegenüber herkömmlichen Lösungen deutlich vereinfacht wird.

Bei der Umsetzung der Erfindung können wegen der gegenüber herkömmlichen Lösungen freieren Wahl der Geometrie der Prüfkammer auch zusätzliche abgeschirmte Räume, wie beispielsweise Steuerungs- oder Verstärkerräume, vorgesehen werden, ohne daß deswegen ein größeres Gebäude als bei herkömmlicher Prüfkammergeometrie benötigt wird. Darüber hinaus kann mit Hilfe der vorliegenden Erfindung auf einfache Weise auf sich ändernde räumliche Bedingungen reagiert werden, beispielsweise wenn die Prüfkammer vergrößert oder verkleinert werden soll. Durch die individuell mögliche Anpaßbarkeit der Meßanordnungen an die neuen Gegebenheiten kann das Konzept der mehrfachen Meßachsen in einer Prüfkammer auch bei Änderurgen in Größe und Form realisiert werden.

Gemäß der vorliegenden Erfindung ist die Prüfkammer, die beispielsweise auch als Absorberkammer oder Absorberhalle bezeichnet werden kann, als sogenannter Halbabsorberraum (semi anechoic chamber) ausgeführt. Im Gegensatz zu einem Vollabsorberraum (fully anechoic chamber), in dem sämtliche Wand-, Boden- und Deckenflächen mit Absorbern versehen sind, ist der Boden des Halbabsorberraumes mit einer vollreflektierenden Metallplatte (ground plane) ausgelegt.

Die erfindungsgemäße Prüfkammer ist zur Durchführung unterschiedlicher EMV-Meßprüfverfahren ausgebildet. Dies erfolgt durch aufeinanderfolgende Bereitstellung mehrerer Meßanordnungen mit unterschiedlichen Meßachsen. In ein und derselben Prüfkammer können also abwechselnd nacheinander zwei oder mehr, insbesondere jedoch drei verschiedene Meßanordnungen normenkonform realisiert werden. Es handelt sich dabei insbesondere um die Meßanordnungen für Emission und Immunität. Jede dieser Meßanordnungen weist dabei eine eigene Meßachse auf, die sich jeweils von den Meßachsen der anderen Meßanordnungen unterscheidet. Im Inneren der Prüfkammer finden mit anderen Worten drei Meßachsen Platz, die, wie nachfolgend noch genauer beschrieben wird, auf besondere Weise zueinander angeordnet sind.

Im Inneren der Prüfkammer sind mehrere, den jeweiligen Prüf normen entsprechende, voneinander verschiedene Antennen dauerhaft angeordnet. Das bedeutet, daß diese Antennen während der Durchführung der unterschiedlichen Meßprüfverfahren in der Prüfkammer verbleiben. Es erfolgt kein Ein- oder Ausbau der Antennen zwischen den verschiedenen Meßprüfungen. Vorzugsweise sind in der Prüfkammer drei unterschiedliche Antennen angebracht. Unter einer Antenne kann dabei, je nach Meßprüfverfahren, auch eine Kombination mehrerer Antennen, insbesondere in Form vor. Antennenpaaren, verstanden werden. Auch kann es sich, je nach Meßprüfverfahren, um Sende und/oder Empfangsantennen handeln.

Jede dieser Antennen ist, um die erforderliche Meßanordnung für das jeweilige Meßprüfverfahren zu realisieren, von einer definierten Ruheposition (Parkposition), in welcher die Antenne nicht verwendet wird, in wenigstens eine definierte, der jeweiligen Meßanordnung zugewiesene Meßposition und zurück bewegbar.

Die Antennen sind jeweils zwischen ihrer Ruhe- und Meßposition, je nach Ausführung der Prüfkammer, manuell, halbautomatisch oder vollautomatisch bewegbar. Die Bewegung der Antennen erfolgt dabei den Normen entsprechend, insbesondere horizontal. Vorzugsweise handelt es sich bei der Bewegung der Antennen um ein Verschieben der entsprechenden Bauteile entlang einer Führungsschiene oder unter Zuhilfenahme einer anderen geeigneten Führungseinrichtung. Je nach Ausführung ist jedoch auch eine freie Bewegung der Antennen ohne Zuhilfenahme eines separaten, als Führungselement dienenden Bauteils innerhalb der Prüfkammer möglich.

Die Erfindung ermöglicht, wie oben bereits angegeben, die dauerhafte, vereinte Unterbringung des Meßequipments für drei EMV-Meßprüfverfahren auf kleinstmöglichem Raum mit geringstmöglichen gegenseitigen Beeinflussungen, Störungen und elektrischen Anregungen. Um dies zu erreichen, befinden sich alle gerade nicht für die Durchführung des laufenden Meßprüfverfahrens benötigten Antennen in ihrer Ruheposition innerhalb der Prüfkammer, in der sie sich sowohl von dem Prüfvolumen, insbesondere dem Prüfling, als auch von der gerade aktiven Antenne soweit weg wie möglich befinden. Sowohl die Meßposition der aktiven Antenne und die Position des Prüfvolumens in der Prüfkammer als auch die Lage der Ruhepositionen alle anderen Komponenten sind dabei unter Berücksichtigung der Einhaltung aller entsprechenden Prüfnormen so gewählt, daß die Entfernungen und die Winkel zwischen diesen Objekten maximal sind. Insbesondere die Antennen, aber auch alle anderen Komponenten des Prüfequipments, sind mit anderen Worten entsprechend den vorgegebenen bzw. zur Verfügung stehenden räumlichen Gegebenheiten und den daraus folgenden Eigenschaften des Raumes, insbesondere den Raumabmessungen und der Raumgeometrie, derart positioniert und ausgerichtet, daß die gegenseitige Beeinflussung während der Durchführung der verschiedenen Meßprüfverfahren jeweils minimal ist. Insbesondere die Geometrie des Raumes bestimmt dabei die optimale Lage der Meßachsen und damit ein definiertes Layout der Prüfkammer mit bestimmten Meß- und Ruhepositionen von Antennen und Bodenabsorbern. Hieraus ergeben sich auch die Lagen der Meßachsen innerhalb des Raumvolumens der Prüfkammer.

Für die Ausführung der oben genannten Meßprüfverfahren für Emission und Immunität werden drei Meßanordnungen mit drei verschiedenen Meßachsen bereitgestellt, wobei die zwischen Antenne und Mittelpunkt des Prüfvolumens verlaufende Meßachse dabei unter anderem durch die Ausrichtung der Antenne zum Prüfling, die Entfernung der Antenne zum Prüfling und ihre Lage im Inneren der Prüfkammer definiert ist. Hieraus ergibt sich eine sternförmige, entsprechend der Längen der normenkonformen Prüfabstände insbesondere Y-förmige Anordnung der Meßachsen mit einer längeren und zwei kürzeren Meßachsen, wobei sich die Meßachsen im Zentrum des Prüfvolumens schneiden. Die Antennen sind mit anderen Worten nicht aufeinander zu gerichtet. Einen ausreichend großen zur Verfügung stehenden Raum vorausgesetzt, befinden sich die drei Meßachsen in einem weitestmöglichen Winkelabstand zueinander, wobei sich zugleich die Ruhepositionen der nichtaktiven Antennen in einer weitestmöglichen Entfernung von der Meßposition der aktiven Antenne und von dem Zentrum des Prüfvolumens befinden, jeweils unter Einhaltung der entsprechenden Normen. Je nach Raumgröße und Form der Prüfkammer können auch von diesen Maximalabständen abweichende Winkelabstände zwischen den Meßachsen bzw. von den Maximalentfernungen abweichende Entfernungen vorgesehen werden, solange sich im Ergebnis ein normenentsprechendes Meßumfeld ergibt. Bei den für die EMV-Meßprüfungen relevanten Prüfnormen handelt es sich im einzelnen um die Normen CISPR 16-2-3/EN55016-2-3, CISPR 22/EN 55022, CISPR 11/EN 55011, CISPR 14-1/EN 55014-1 und CISPR 32/EN 55032 für die Emissionsprüfungen sowie um die Norm IEC/EN 61000-4-3 für die Immunitätsprüfungen.

Die Erfindung ist nicht auf die Bereitstellung von drei Meßanordnungen beschränkt. Ebenso kann eine andere Mehrzahl von Meßanordnungen bereitgestellt werden, insbesondere mit mehr als einer Meßachse. Auch muß dabei die Anordnung der Meßachsen nicht zwingend Y-förmig sein. Je nach Anzahl der benötigten Meßachsen kann auch eine andere sternförmige Anordnung vorteilhaft sein, beispielsweise eine X-förmige Anordnung der Meßachsen. Wenn die Größe der Prüfkammer ausreichend ist, können auch mehrere Gruppen von Meßanordnungen im Inneren einer Prüfkammer untergebracht werden, wenn eine gegenseitige Beeinflussung der verschiedenen Gruppen von Meßanordnungen ausgeschlossen werden kann. So können beispielsweise in einer Prüfkammer eine erste Gruppe von Meßanordnungen mit drei Y-förmig angeordneten Meßachsen sowie eine zweite Gruppe von Meßanordnungen mit drei weiteren, Y-förmig angeordneten Meßachsen vorgesehen sein.

Kommen, dem jeweiligen Meßprüfverfahren entsprechend, Bodenabsorber bzw. Bodenabsorberfelder zum Einsatz, dann werden diese vorzugsweise genauso wie Antennen bewegt und positioniert. Die jeweils einem der Meßprüfverfahren zugeordneten normentsprechenden Bodenabsorber werden also zur Bereitstellung der Meßanordnung für das jeweilige Meßprüfverfahren von einer Ruheposition innerhalb der Prüfkammer in ihre jeweilige Meßposition bewegt. Nicht benötigte Bodenabsorber befinden sich währenddessen in ihrer Ruheposition, die derart gewählt ist, daß sie als Lagerplatz geeignet ist, ohne die Prüfkammereigenschaften negativ zu beeinflussen. Mit anderen Worten ermöglicht die erfindungsgemäße Prüfkammer veränderbare, individuell für jede Meßachse konfigurierbare Bodenabsorberbereiche. Wie bereits im Bezug auf die Antennen beschrieben, sind auch die Meß- und Ruhepositionen der Bodenabsorber so gewählt, daß eine Beeinflussung der anderen Komponenten des Prüfequipments minimal ist, jedenfalls aber den entsprechenden Normen genügt.

Die erfindungsgemäße Prüfkammer zeichnet sich darüber hinaus vorzugsweise dadurch aus, daß die Bewegung der Antennen bzw.

Bodenabsorberfelder innerhalb der Prüfkammer entlang definierter Bahnen erfolgt, insbesondere entlang der Meßachsen. Ganz besonders vorteilhaft ist es, wenn diese Bewegungen ausschließlich entlang definierter Bahnen, insbesondere ausschließlich entlang der Meßachsen erfolgen. Mit anderen Worten ist jede der Antennen und/oder jeder der Bodenabsorber vorzugsweise entlang ein- und derselben Meßachse der Meßanordnung des jeweiligen Meßprüfverfahren innerhalb der Prüfkammer von ihrer Ruheposition in ihre Meßposition und zurück bewegbar. Der Verlauf der Meßachsen definiert mit anderen Worten die Bewegungsachsen für Antennen und Bodenabsorber. Anders formuliert folgt der Verlauf der Meßachsen den Bewegungsachsen der Antennen bzw. Bodenabsorberfeldern. Hinsichtlich der Antennen bedeutet "entlang der Meßachse" (axial), daß die Bewegung der Antennen in der Meßachse erfolgt. Hinsichtlich der auf dem Boden der Prüfkammer anzuordnenden Bodenabsorber bedeutet es hingegen, daß die Bodenabsorber parallel zu der Meßachse bewegt werden. Insbesondere, weil Bodenabsorber und Antennen auf diese Weise wiederholbar exakt plaziert werden können, ist ein hohes Maß an Reproduzierbarkeit der Meßprüfungen gegeben. Zugleich macht es ein Bewegen der Antennen auf den Meßachsen einfacher, die benötigten Meßentfernungen bei unterschiedlich großen Prüflingen herzustellen.

In diesem Zusammenhang ist eine Bewegung der Antennen oder Bodenabsorber "entlang einer Meßachse" stets so zu verstehen, daß die Bewegungsrichtung zwar der Richtung der Meßachse entspricht, die Reichweite der Bewegung dabei jedoch nicht durch die Länge der Meßachse begrenzt ist. Anders ausgedrückt kann die Bewegung der Antennen oder Bodenabsorber auch über die oben genannten Fixpunkte (Meßposition der Antenne, Zentrum des Prüfvolumens) hinaus in einer Verlängerung der Meßachse erfolgen, insbesondere bei einer Bewegung der Komponenten in ihre Ruhepositionen.

Besonders vorteilhaft ist eine Ausführungsform der Erfindung, bei der die jeweils einem der Meßprüfverfahren zugeordneten Antennen und Bodenabsorber unabhängig voneinander, dabei jedoch in gleicher Richtung, nämlich vorzugsweise entlang der ihnen jeweils zugeordneten Meßachse, von ihrer Ruheposition in ihre Meßposition und zurück bewegbar sind. Eine solche Bewegung von Antennen und Bodenabsorber unabhängig voneinander erlaubt auf einfache Weise die normengerechte Durchführung der Meßprüfverfahren auch bei unterschiedlichen Prüfvolumen bzw. Prüflingen und hierdurch erforderlichen unterschiedlichen Meßentfernungen. Eine unabhängig voneinander erfolgende Bewegung der Antennen und Bodenabsorber kann aber auch in unterschiedlicher Richtung erfolgen.

In einer anderen Ausführungsform der Erfindung kann es vorteilhaft sein, wenn Antenne und Bodenabsorber nicht unabhängig voneinander bewegbar, sondern statt dessen nur miteinander bewegbar sind. In diesem Fall bilden Antenne und Absorber vorzugsweise eine konstruktive Einheit. Beispielsweise ist eine Antenne mit einem zur Ausbildung der entsprechenden Meßanordnung geeigneten Bodenabsorber bzw. Bodenabsorberfeld verschraubt.

In alternativen Ausführungsformen der Erfindung können die Antennen und/oder Bodenabsorber bzw. Bodenabsorberfelder jedoch auch auf andere Weise in ihre Meßposition bewegt werden, beispielsweise versetzt zu den Meßachsen, von der Seite einschwenkend, von oben herunterfahrend oder von unten hochfahrend. So kann insbesondere auch eine nicht-axiale Verschiebung der Bodenabsorber in die jeweilige Meß- oder Ruheposition erfolgen, beispielsweise aufgrund einer speziellen vorgegebenen Prüfkammergeometrie.

Das Bewegen der Antennen und/oder der Bodenabsorber bzw. Bodenabsorberfelder zwischen ihren Positionen kann beispielsweise auf dafür vorgesehenen Schienen erfolgen. Anstelle der Schienen können aber auch andere Verfahrmittel verwendet werden, beispielsweise Rollen, die an den Antennen bzw. an den Absorbern befestigt sind. Dabei sind die Verfahrwege nicht in allen Ausführungsformen der Erfindung vorgegeben. Auch ein freies Bewegen von Antennen und/oder Absorbern innerhalb der Prüfkammer ist möglich.

In weiteren Ausführungsformen der Erfindung sind nicht sämtliche Antennen bzw. nicht sämtliche Bodenabsorber oder Bodenabsorberfelder dauerhaft in der Prüfkammer angeordnet. Der Grundgedanke der Erfindung, mehrere Meßanordnungen mit unterschiedlichen Meßachsen zur Durchführung unterschiedlicher EMV-Meßprüfverfahren in ein und derselben Prüfkammer bereitzustellen, läßt sich auch bei Systemen realisieren, bei denen Antennen und/oder Absorber nicht nur innerhalb der Prüfkammer bewegt werden können, sondern auch aus der Prüfkammer heraus und in die Prüfkammer hinein bewegt werden können. Mit anderen Worten können Ruhepositionen von Antennen bzw. Absorbern auch außerhalb der Prüfkammer vorgesehen sein. Vorzugsweise befindet sich jedoch zumindest der Bodenabsorber bzw. das Bodenabsorberfeld dauerhaft innerhalb der Prüfkammer, um die zurückzulegende Strecke dieser meist vergleichsweise schweren Systemkomponente zu minimieren.

Ein Ausführungsbeispiel der Erfindung wird nachfolgend anhand der Zeichnungen näher erläutert. Hierbei zeigen:
- Fig. 1: eine Prüfkammer mit drei Meßachsen, in Draufsicht,
- Fig. 2: die Prüfkammer aus Fig. 1, ausgebildet für eine Enissionsprüfung, in Draufsicht,
- Fig. 3: die Prüfkammer aus Fig. 2, ausgebildet für eine Emissionsprüfung sowie eine Immunitätsprüfung in einem ersten Frequenzbereich, in Draufsicht,
- Fig. 4: die Prüfkammer aus Fig. 2, ausgebildet für eine Immunitätsprüfung in einem zweiten Frequenzbereich, in Draufsicht.

Sämtliche Figuren zeigen die Erfindung nicht maßstabsgerecht, dabei lediglich schematisch und nur mit ihren wesentlichen Bestandteilen. Gleiche Bezugszeichen entsprechen dabei Elementen gleicher oder vergleichbarer Funktion.

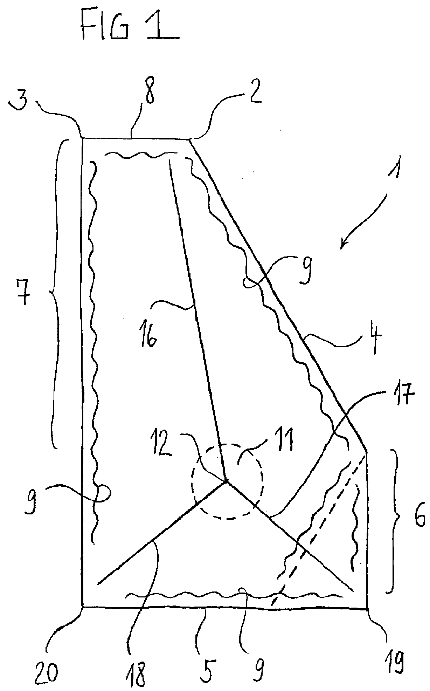

In Fig. 1 ist eine Ausführungsform einer erfindungsgemäßen Prüfkammer 1 in Draufsicht schematisch skizziert. Die Prüfkammer 1 ist zur Durchführung von EMV-Meßprüfungen ausgebildet.

Die in ihrer Geometrie durch die lokalen baulichen Gegebenheiten vorgegebene Prüfkammer 1 weist beispielhaft den Grundriß eines konvexen Fünfecks auf, der dadurch erreicht wird, daß ein Eckpunkt 2 eines ursprünglich rechteckigen Raumes in Richtung eines ihm benachbarten Eckpunktes 3 verschoben wurde, dies jedoch unter Schrägstellung lediglich eines Abschrittes einer sich an diesen Eckpunkt 2 anschließenden Längsseite 4 des Raumes derart, daß der sich ergebende Raum ausgehend von einer ersten Kopfseite 5 zunächst einen konstant breiten ersten Raumabschnitt 6 aufweist, siehe Fig. 1. An diesen ersten Raumabschnitt 6 schließt sich ein zweiter Raumabschnitt 7 an, dessen Breite, beginnend mit der Schrägstellung der einen Längsseite 4, bis zu der gegenüberliegenden zweiten Kopfseite 8 des Raumes kontinuierlich abnimmt.

Die Wände und die Decke der Prüfkammer 1 sind auf bekannte Art und Weise mit geeigneten Absorbern 9 für elektromagnetische Wellen versehen (aus Gründen der Übersichtlichkeit nur in Fig. 1 angedeutet). In einem zentralen Bereich der Prüfkammer 1 ist das Prüfvolumen 11 vorgesehen, also der Bereich, in dem ein Prüfling 10 während der Messungen angeordnet ist. Das Prüfvolumen 11 befindet sich noch primär im ersten Raumabschnitt 6 der Prüfkammer 1. Oftmals ist eine Drehscheibe zur normenentsprechenden Positionierung des Prüflings vorgesehen. Während einer EMV-Meßprüfung ist der Prüfling 10, den Prüfnormen entsprechend, im Zentrum 12 des Prüfvolumens 11 positioniert.

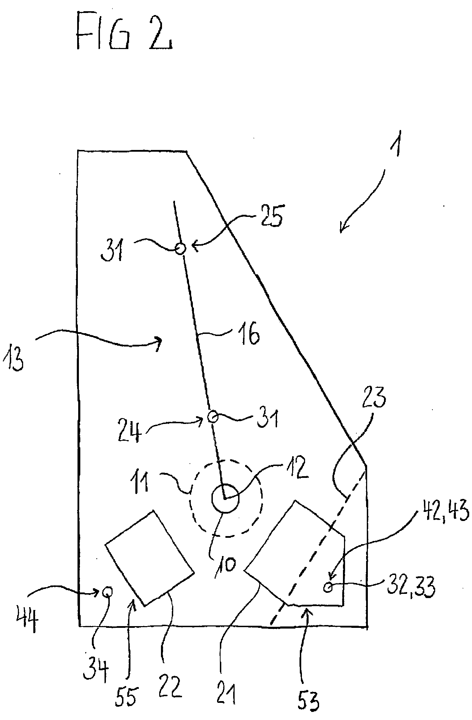

In der Prüfkammer 1 sind drei grundlegende Meßanordnungen 13, 14, 15 realisiert, siehe Fig. 2, 3, 4, deren voneinander verschiedene Meßachsen sternförmig, genauer gesagt Y-förmig, angeordnet sind und sich im Zentrum 12 des Prüfvolumens 11 treffen. Es handelt sich dabei um eine erste Meßachse 16, die zur Prüfung der Emission in einem ersten Frequenzbereich dient, um eine zweite Meßachse 17, die zur Prüfung der Emission in einem zweiten Frequenzbereich sowie zur Prüfung der Immunität in einem ersten Frequenzbereich dient und um eine dritte Meßachse 18, die zur Prüfung der Immunität in einem zweiten Frequenzbereich dient.

Zur Realisierung der Meßanordnungen sind in der Prüfkammer mehrere Antennen 31, 32, 33, 34 sowie Bodenabsorberfelder 21, 22 vorhanden. Wie nachfolgend noch genauer erläutert, sind in einer bevorzugten Ausführungsform der Erfindung lediglich drei Antennen 31, 32, 34 notwendig, da zur Messung desselben Frequenzbereiches dieselben Antennen 32, 33 verwendet werden können.

In der hier beispielhaft diskutierten Prüfkammer 1 ist die erste Meßachse 16 leicht schräg, von der Mittellängsachse des Raumes abweichend, den sich zu der zweiten Kopfseite 8 hin verjüngenden Raum etwa halbierend positioniert, während sich die zweite Meßachse 17 und die dritte Meßachse 18 ausgehend von dem Zentrum 12 des Prüfvolumens 11 in Richtung der beiden die erste Kopfseite 5 begrenzenden rechtwinkeligen Ecken 19, 20 des ersten Raumabschnittes 6 erstrecken, siehe Fig. 1.

Die Anordnung der Meßachsen 16, 17, 18 und damit die Definition der Meß- und Ruhepositionen erfolgt derart, daß bei Einhaltung der einschlägigen Normen für die jeweiligen Meßprüfverfahren die gegenseitige Beeinflussung minimal ist und alle Komponenten des Prüfequipments im Inneren der Prüfkammer 1 verbleiben können. Demnach befinden sich die Ruhepositionen der Antennen 31, 32, 33, 34 und Bodenabsorberfelder 21, 22 im Idealfall jeweils in den am weitesten von dem Zentrum 12 des Prüfvolumens 11 entfernten Bereichen der Prüfkammer 1, hier also im Bereich der entfernt von dem Prüfvolumen 11 vorgesehenen zweiten Kopfseite 8 bzw. in den beiden genannten Ecken 19, 20 des ersten Raumabschnittes 6.

Die Durchführung der EMV-Meßprüfung wird nachfolgend an einem Beispiel beschrieben.

In Fig. 2 dargestellt ist die Meßanordnung 13 zur Emissionsprüfung im Frequenzbereich von 30 MHz bis 1 GHz. Bei einer Meßentfernung von drei Metern befindet sich die hierfür benötigte normentsprechende erste Antenne 31 in einer ersten Meßposition 24, drei Meter von derr. Prüfling 10 entfernt, auf der ersten Meßachse 16. Für die Messung in einer Meßentfernung von zehn Metern befindet sich die erste Antenne 31 in einer zweiten Meßposition 25, zehn Meter von dem Prüfling 10 entfernt.

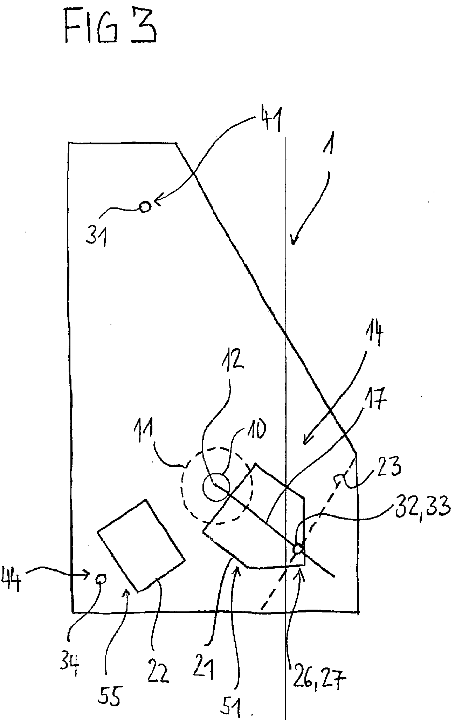

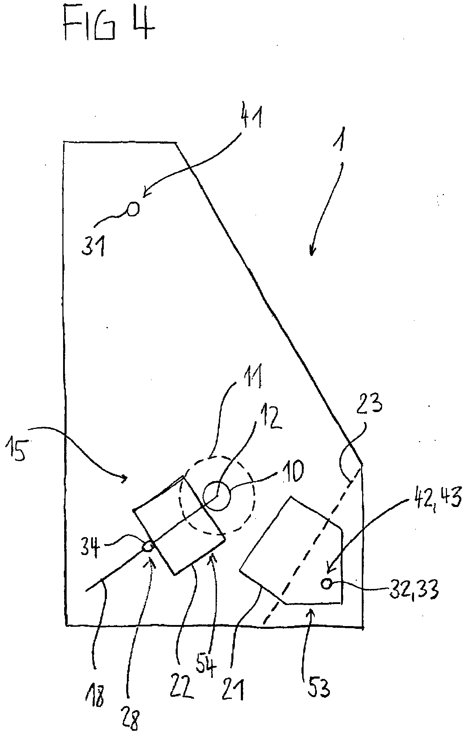

Bodenabsorberfelder 21, 22 kommen nicht zum Einsatz. Während der Emissionsmessung befinden sich die nicht aktiven Antennen 32, 33, 34 und die Bodenabsorberfelder 21, 22 in ihren Ruhepositionen 42, 43, 44, 53, 55. Nach Abschluß der Emissionsprüfung wird die erste Antenne 31 entlang der ersten Meßachse 16 in ihre Ruheposition 41 bewegt, die sich hinter der zweiten Meßposition 25 in einer gedachten Verlängerung der ersten Meßachse 16 und somit weitestmöglich von dem Zentrum 12 des Prüfvolumens 11 entfernt befindet, wie in den Fig. 3 und 4 abgebildet.

In Fig. 3 dargestellt ist die Meßanordnung 14 zur Emissionsprüfung im Frequenzbereich von 1 GHz bis 18 GHz. Die hierfür benötigte normentsprechende zweite Antenne 32 befindet sich in ihrer Meßposition 26 auf der zweiten Meßachse 17. Das für diese Prüfung ausgebildete erste Bodenabsorberfeld 21 befindet sich in seiner Meßposition 51, mit seinem vorderen Rand unmittelbar am Prüfling 10. Die Entfernung der zweiten Antenne 32 bis zum Prüfling 10 beträgt drei Meter. Während der Emissionsprüfung befinden sich die nicht aktiven Antennen 31, 33, 34 und das zweite Bodenabsorberfeld 22 in ihren Ruhepositionen 41, 43, 44, 55. Nach Abschluß der Prüfung wird die zweite Antenne 32 entlang der zweiten Meßachse 17 in ihre Ruheposition 42 bewegt, die sich hinter ihrer Meßposition 26 in einer gedachten Verlängerung der zweiten Meßachse 17 und somit weitestmöglich von dem Zentrum 12 des Prüfvolumens 11 entfernt befindet, wie in den Fig. 2 und 4 abgebildet.

In ihrer Ruheposition 42 wird die zweite Antenne 32 hinter einer mit den üblichen Absorbern 9 versehenen, zu diesem Zweck vorgesehenen Zusatzwand 23 angeordnet. Die Zusatzwand 23 dient zur Abdeckung der Ruheposition und weist eine Öffnung zum Ein-und Ausfahren der Antenne 32, 33 und des Bodenabsorberfeldes 22 auf. Ebenso wird der ersten Bodenabsorber 21 entlang der zweiten Meßachse 17 in seine Ruheposition 53 bewegt, die sich hinter seiner Meßposition 51 in einer gedachten Verlängerung der zweiten Meßachse 17 und somit weitestmöglich von dem Zentrum 12 des Prüfvolumens 11 entfernt befindet, wie in den Fig. 2 und 4 abgebildet. Das erste Bodenabsorberfeld 21 befindet sich in seiner Ruheposition 53 ebenfalls zumindest teilweise hinter der Zusatzwand 23.

Dieselbe in Fig. 3 dargestellte Meßanordnung 14 wird zur Immunitätsprüfung in dem Frequenzbereich von 1 GHz bis 18 GHz verwendet. Hervorzuheben ist, daß dabei vorzugsweise dieselbe Antenne 32 zum Einsatz kommt. Es kann jedoch auch eine andere geeignete dritte Antenne 33 verwendet werden. Die Meß- und Ruhepositionen 27, 43 der dritten Antenne 33 entsprechen dabei den Meß- und Ruhepositionen 26, 42 der zweiten Antenne 32. Bei der Realisierung der Meßanordnung 14 kommt erneut das erste Bodenabsorberfeld 21 zum Einsatz. Dessen Meß- und Ruhepositionen 51, 53 bleiben unverändert.

In Fig. 4 dargestellt ist die Meßanordnung 15 zur Immunitätsprüfung in dem Frequenzbereich von 80 MHz bis 1 GHz. Die hierfür benötigte normentsprechende vierte Antenne 34 befindet sich in ihrer Meßposition 28 auf der dritten Meßachse 18, drei Meter von dem Prüfling entfernt. Das für die Verwendung bei dieser Messung ausgebildete zweite Bodenabsorberfeld 22 befindet sich dabei in seiner Meßposition 54, mit seinem vorderen Rand unmittelbar an dem Prüfling 10. Während dieser Immunitätsprüfung befinden sich die nicht aktiven Antennen 31, 32, 33 und das erste Bodenabsorberfeld 21 in ihren Ruhepositionen 41, 42, 43, 53. Nach Abschluß dieser Messung wird die vierte Antenne 34 entlang der dritten Meßachse 18 in ihre Ruheposition 44 bewegt, die sich hinter ihrer Meßposition 28 in einer gedachten Verlängerung der dritten Meßachse 18 und somit weitestmöglich von dem Zentrum 12 des Prüfvolumens 11 entfernt befindet, wie in den Fig. 2 und 3 abgebildet. Ebenso wird das zweite Bodenabsorberfeld 22 entlang der dritten Meßachse 18 in seine Ruheposition 55 bewegt, die sich hinter seiner Meßposition 54 in einer gedachten Verlängerung der dritten Meßachse 18 und somit weitestmöglich von dem Zentrum 12 des Prüfvolumens 11 entfernt befindet, wie in den Fig. 2 und 3 abgebildet.

Soweit die Beschreibung der EMV-Meßprüfung. Wenngleich die in den Fig. 2, 3 und 4 abgebildeten Meßanordnungen 13, 14, 15 zuvor in Bezug auf die EMV-Meßprüfung innerhalb der Prüfkammer 1 beschrieben wurden, so entspricht dieser Aufbau doch im wesentlichen den Meßanordnungen bei der Durchführung entsprechender Validierungsmessungen zur Validierung der Prüfkammer 1. Gleiches gilt für die oben beschriebenen Meß- und Ruhepositionen der Antennen 31, 32, 33, 34 und Bodenabsorber 21, 22. So kann die erste Meßanordnung 13 bei der Durchführung des NSA-Prüfverfahrens, die zweite Meßanordnung 14 bei der Durchführung des SVSWR-Prüfverfahrens und bei der Messung der Feldhomogenität in einem ersten Frequenzbereich, und die dritte Meßanordnung 15 bei der Messung der Feldhomogenität in einem zweiten Frequenzbereich genutzt werden.

Die Antennen 31, 32, 33, 34 sind in der Regel höhenverstellbar und in einem Ausführungsbeispiel an Führungsschienen (nicht dargestellt) entlang ihrer Meßachsen verfahrbar. Für die Bewegung der Antennen 31, 32, 33, 34 und Bodenabsorber 21, 22 können mit entsprechenden Steuerungen versehene elektromotorische Antriebe oder andere geeignete Mittel eingesetzt werden.

Alle in der Beschreibung, den nachfolgenden Ansprüchen und der Zeichnung dargestellten Merkmale können sowohl einzeln. als auch in beliebiger Kombination miteinander erfindungswesentlich sein.

### Bezugszeichenliste

- 1: Prüfkammer
- 2: Eckpunkt
- 3: Eckpunkt
- 4: Längsseite mit schrägstehendem Abschnitt
- 5: erste Kopfseite
- 6: erster Raumabschnitt
- 7: zweiter Raumabschnitt
- 8: zweite Kopfseite
- 9: Absorber
- 10: Prüfling
- 11: Prüfvolumen
- 12: Zentrum des Prüfvolumens
- 13: erste Meßanordnung
- 14: zweite Meßanordnung
- 15: dritte Meßanordnung
- 16: erste Meßachse
- 17: zweite Meßachse
- 18: dritte Meßachse
- 19: Ecke
- 20: Ecke
- 21: erster Bodenabsorber, erstes Bodenabsorberfeld
- 22: zweiter Bodenabsorber, zweites Bodenabsorberfeld
- 23: Zusatzwand
- 24: erste Meßposition (Emissionsmessung bis 1 GHz)
- 25: zweite Meßposition (Emissionsmessung bis 1 GHz)
- 26: Meßposition (Emissionsmessung über 1 GHz)
- 27: Meßposition (Immunitätsmessung über 1 GHz)
- 28: Meßposition (Immunitätsmessung bis 1 GHz)
- 29: (frei)
- 30: (frei)
- 31: erste Antenne
- 32: zweite Antenne
- 33: dritte Antenne
- 34: vierte Antenne

- 41: Ruheposition der ersten Antenne
- 42: Ruheposition der zweiten Antenne
- 43: Ruheposition der dritte Antenne
- 44: Ruheposition der vierten Antenne

- 51: Meßposition des ersten Bodenabsorbers
- 52: (frei)
- 53: Ruheposition des ersten Bodenabsorbers
- 54: Meßposition des zweiten Bodenabsorbers
- 55: Ruheposition des zweiten Bodenabsorbers

## Patentansprüche

1. Prüfkammer (1) für die EMV-Meßprüfung, ausgebildet zur Durchführung unterschiedlicher EMV-Meßprüfverfahren durch Bereitstellung mehrerer Meßanordnungen (13, 14, 15) mit unterschiedlichen Meßachsen (16, 17, 18), wobei in der Prüfkammer (1) mehrere Antennen (31, 32, 33, 34) gleichzeitig angeordnet sind, wobei jede dieser Antennen (31, 32, 33, 34) jeweils mindestens einem der Meßprüfverfahren zugeordnet ist und wobei jede dieser Antennen (31, 32, 33, 34) zur Bereitstellung der Meßanordnung (13, 14, 15) für das jeweilige Meßprüfverfahren von einer Ruheposition (41, 42, 43, 44) in eine dieser Meßanordnung (13, 14, 15) zugeordnete Meßposition (24, 25, 26, 27, 28) und zurück bewegbar ist.

2. Prüfkammer (1) nach Anspruch 1, wobei in der Prüfkammer (1) mindestens drei verschiedene Antennen (31, 32, 33, 34) angeordnet sind, ausgebildet zur Durchführung mehrerer unterschiedlicher EMV-Meßprüfverfahren durch Bereitstellung von wenigstens drei Meßanordnungen (13, 14, 15).

3. Prüfkammer (1) nach Anspruch 1 oder 2, wobei die Meß- und Ruhepositionen (24, 25, 26, 27, 28, 41, 42, 43, 44) der Antenne (31, 32, 33, 34) unter Berücksichtigung der Eigenschaften des innerhalb der Prüfkammer (1) zur Verfügung stehenden Raumes derart gewählt sind, daß jeweils zwischen den sich in ihrer Ruheposition (41, 42, 43, 44) befindenden Antennen (31, 32, 33, 34) einerseits und der sich in ihrer Meßposition (24, 25, 26, 27, 28) befindenden Antenne (31, 32, 33, 34) sowie dem Prüfling (10) andererseits ein zur Normerfüllung geeigneter Winkelabstand und/oder Abstand besteht.

4. Prüfkammer (1) nach einem der Ansprüche 1 bis 3, wobei die Meßpositionen (24, 25, 26, 27, 28) der Antennen (31, 32, 33, 34) derart gewählt sind, daß die Meßachsen (16, 17, 18) der sich ergebenden Meßanordnungen (13, 14, 15) derart zueinander angeordnet sind, daß sich eine Y-Form ergibt.

5. Prüfkammer (1) nach einem der Ansprüche 1 bis 4, mit einer Anzahl in der Prüfkammer (1) angeordneter, jeweils mindestens einem der Meßprüfverfahren zugeordneter Bodenabsorber oder Bodenabsorberfelder (21, 22), wobei jeder dieser Bodenabsorber bzw. jedes dieser Bodenabsorberfelder (21, 22) zur Bereitstellung einer Meßanordnung (14, 15) für das jeweilige Meßprüfverfahren von einer Ruheposition (53, 55) in eine dieser Meßanordnung (14, 15) zugewiesene Meßposition (51, 54) und zurück bewegbar ist.

6. Prüfkammer (1) nach einem der Ansprüche 1 bis 5, wobei jeder der Antennen (31, 32, 33, 34) und/oder jeder der Bodenabsorber bzw. jedes der Bodenabsorberfelder (21, 22) entlang der Meßachse (16, 17, 18) der Meßanordnung (13, 14, 15) des jeweiligen Meßprüfverfahrens bewegbar ist.

7. Prüfkammer (1) nach einem der Ansprüche 1 bis 6, wobei die jeweils einem der Meßprüfverfahren zugeordneten Antennen (31, 32, 33, 34) und Bodenabsorber oder Bodenabsorberfelder (21, 22) unabhängig voneinander bewegbar sind.

8. Verfahren zur Validierung einer Prüfkammer (1) für die EMV-Meßprüfung, welche Prüfkammer (1) ausgebildet ist zur Durchführung unterschiedlicher EMV-Meßprüfverfahren durch Bereitstellung mehrerer Meßanordnungen (13, 14, 15) mit unterschiedlichen Meßachsen (16, 17, 18), wobei in der Prüfkammer (1) mehrere Antennen (31, 32, 33, 34) gleichzeitig angeordnet sind, wobei jede dieser Antennen (31, 32, 33, 34) jeweils mindestens einem der Meßprüfverfahren zugeordnet ist und wobei sich während der Validierung dieser Prüfkammer (1) jeweils eine dieser Antennen (31, 32, 33, 34) zur Bereitstellung einer zu validierenden Meßanordnung (13, 14, 15) in einer dieser Meßanordnung (13, 14, 15) zugeordneten Meßposition (24, 25, 26, 27, 28) befindet, während sich die jeweils anderen Antennen (31, 32, 33, 34) in ihren von ihren Meßpositionen verschiedenen Ruhepositionen (41, 42, 43, 44) befinden.

9. Verfahren nach Anspruch 8, wobei in der Prüfkammer (1) eine Anzahl Bodenabsorber oder Bodenabsorberfelder (21, 22) angeordnet sind, wobei jeder dieser Bodenabsorber oder jedes dieser Bodenabsorberfelder (21, 22) jeweils mindestens einem der Meßprüfverfahren zugeordnet ist und wobei zum Zweck der Validierung dieser Prüfkammer (1) jeweils einer dieser Bodenabsorber oder eines dieser Bodenabsorberfelder (21, 22) zur Bereitstellung einer zu validierenden Meßanordnung (13, 14, 15) in eine dieser Meßanordnung (13, 14, 15) zugeordnete Meßposition (51, 54) bewegt wird.

10. Verfahren nach Anspruch 8 oder 9, wobei in der Prüfkammer (1) mehrere Bodenabsorber oder Bodenabsorberfelder (21, 22) gleichzeitig angeordnet sind, wobei jede dieser Bodenabsorber oder jedes dieser Bodenabsorberfelder (21, 22) jeweils mindestens einem der Meßprüfverfahren zugeordnet ist und wobei sich während der Validierung dieser Prüfkammer (1) jeweils einer dieser Bodenabsorber oder eines dieser Bodenabsorberfelder (21, 22) zur Bereitstellung einer zu validierenden Meßanordnung (13, 14, 15) in einer dieser Meßanordnung (13, 14, 15) zugeordneten Meßposition (51, 54) befindet, während sich die jeweils anderen Bodenabsorber oder Bodenabsorberfelder (21, 22) in ihren von ihren Meßpositionen verschiedenen Ruhepositionen (53, 55) befinden.

11. Verfahren zum Betrieb einer Prüfkammer (1) für die EMV-Meßprüfung, wobei in der Prüfkammer (1) unterschiedliche EMV-Meßprüfverfahren durchgeführt werden, indem nacheinander mehrere Meßanordnungen (13, 14, 15) mit unterschiedlichen Meßachsen (16, 17, 18) bereitgestellt werden, wobei in der Prüfkammer (1) mehrere Antennen (31, 32, 33, 34) gleichzeitig angeordnet sind, wobei jede dieser Antennen (31, 32, 33, 34) jeweils mindestens einem der Meßprüfverfahren zugeordnet ist und wobei jeweils eine dieser Antennen (31, 32, 33, 34) zur Bereitstellung der Meßanordnung (13, 14, 15) für das jeweilige Meßprüfverfahren von einer Ruheposition (41, 42, 43, 44) in eine dieser Meßanordnung (13, 14, 15) zugeordnete Meßposition (24, 25, 26, 27, 28) bewegt wird.

12. Verfahren nach Anspruch 11, wobei sich die jeweils nicht zur Bereitstellung der Meßanordnung (13, 14, 15) für das jeweilige Meßprüfverfahren benötigten Antennen (31, 32, 33, 34) in ihren Ruhepositionen (41, 42, 43, 44) befinden oder in diese Ruhepositionen (41, 42, 43, 44) bewegt werden.

13. Verfahren nach Anspruch 11 oder 12, wobei eine Anzahl in der Prüfkammer (1) angeordneter, jeweils mindestens einem der Meßprüfverfahren zugeordneter Bodenabsorber oder Bodenabsorberfelder (21, 22) vorgesehen sind, die zur Bereitstellung der Meßanordnung (14, 15) für das jeweilige Meßprüfverfahren von einer Ruheposition (53, 55) in eine dieser Meßanordnung (14, 15) zugewiesene Meßposition (51, 54) bewegt werden.

14. Verfahren nach Anspruch 13, wobei sich die jeweils nicht zur Bereitstellung der Meßanordnung (14, 15) für das jeweilige Meßprüfverfahren benötigten Bodenabsorber oder Bodenabsorberfelder (21, 22) in ihren Ruhepositionen (53, 55) befinden oder in diese Ruhepositionen (53, 55) bewegt werden.
